(19) Europäisches Patentamt
European Patent Office
Office européen des brevets

(11) **EP 3 676 624 B1**

(12) **FASCICULE DE BREVET EUROPEEN**

(45) Date de publication et mention de la délivrance du brevet:
**30.06.2021 Bulletin 2021/26**

(21) Numéro de dépôt: **18752725.4**

(22) Date de dépôt: **03.08.2018**

(51) Int Cl.:
***G01R 31/08*** $^{(2020.01)}$

(86) Numéro de dépôt international:
**PCT/EP2018/071146**

(87) Numéro de publication internationale:
**WO 2019/042707 (07.03.2019 Gazette 2019/10)**

(54) **DÉTECTION DE DÉFAILLANCE D'UN RÉSEAU DE DISTRIBUTION ÉLECTRIQUE**

FEHLERERKENNUNG IN EINEM ELEKTRIZITÄTSVERLEINUNGSNETZ

FAULT DETECTION IN AN ELECTRICITY DISTRIBUTION NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.08.2017 FR 1757919**

(43) Date de publication de la demande:
**08.07.2020 Bulletin 2020/28**

(73) Titulaire: **Enedis**
**92079 Paris La Defense Cedex (FR)**

(72) Inventeurs:
• **GAY, Christophe**
**69003 Lyon (FR)**
• **EL KHARRAT, Caroline**
**69410 Champagne au Mont d'Or (FR)**
• **ACHAICHIA, Pierre**
**44000 Nantes (FR)**

(74) Mandataire: **Plasseraud IP**
**66, rue de la Chaussée d'Antin**
**75440 Paris Cedex 09 (FR)**

(56) Documents cités:
**EP-A1- 2 752 674          EP-A2- 2 565 656**
**WO-A1-2015/092279     WO-A2-2013/035110**
**FR-A1- 2 992 733          US-A- 5 568 399**
**US-A1- 2011 153 236     US-A1- 2014 278 162**
**US-A1- 2014 330 531     US-A1- 2016 061 873**
**US-A1- 2016 181 863     US-B1- 6 718 271**

• **BESCHTA A: "A MODEL-BASED APPROACH TO FAULT LOCALISATION IN POWER TRANSMISSION NETWORKS", INTELLIGENT SYSTEMS ENGINEERING, INSTITUTION OF ELECTRICAL ENGINEERS., STEVENAGE, GB, vol. 2, no. 1, 21 mars 1993 (1993-03-21), pages 3-14, XP000362705, ISSN: 0963-9640**

**Description**

L'invention relève du domaine de la gestion d'un réseau de distribution électrique.

Il est de la responsabilité d'un gestionnaire d'un réseau de distribution électrique de surveiller le bon fonctionnement du réseau. Des mesures préventives, notamment l'entretien, permettent de limiter les risques de dysfonctionnement. Des mesures curatives, notamment les interventions d'opérateurs sur le terrain, permettent de réduire la durée et l'ampleur des disfonctionnements lorsqu'ils surviennent. Pour permettre des interventions rapides et efficaces, il convient de détecter la survenance d'un incident au plus tôt et de le qualifier le plus précisément possible.

Les réseaux de transport et de répartition de l'énergie électrique correspondent à la partie amont de l'infrastructure électrique et acheminent l'énergie électrique sur de longues distances. De tels réseaux sont généralement équipés de systèmes de surveillance au moins en partie automatisés. Les réseaux de transport et de répartition comprennent notamment des capteurs aptes à transmettre à distance des données de surveillance de l'état du réseau. Les réseaux de distribution correspondent à la partie avale de l'infrastructure et acheminent l'énergie électrique sur de courtes distances mais jusque chaque nœud de consommation. Les réseaux de distribution sont donc plus denses et nombreux que les réseaux de transport et de répartition. Par conséquent, équiper le réseau de distribution de systèmes de surveillance et en assurer la maintenance présenteraient un coût élevé. Les réseaux de distribution sont généralement dépourvus de tels systèmes de surveillance.

En pratique, un incident sur un réseau de distribution est généralement signalé au gestionnaire du réseau par un ou plusieurs utilisateurs constatant l'interruption de la fourniture d'énergie électrique. De tels signalements, généralement effectués par téléphone, sont peu précis et peu réactifs. Par exemple, il est difficile de distinguer une anomalie sur le réseau de distribution de la responsabilité du gestionnaire d'une anomalie sur le réseau privé (par exemple domestique) de la responsabilité de l'utilisateur lui-même. Il en résulte un nombre important de fausses alertes à traiter.

Depuis peu, les nœuds consommateurs des réseaux de distribution, parfois appelé « Point De Livraison » (PDL), peuvent être équipés de dispositifs communicants. Par exemple, des compteurs communicants, connus sous la référence commerciale « Linky » sont en cours de déploiement en France. De tels compteurs comprennent un module de communication apte à transmettre des données à distance de manière au moins en partie automatisée. De tels modules sont agencés pour transmettre des informations relatives à la consommation en aval du nœud consommateur correspondant, notamment dans un but de facturation. De tels modules ne sont pas prévus pour transmettre des informations relatives au réseau de distribution en amont. Les modules de communication des nœuds consommateurs ne permettent donc pas, en l'état, de détecter des anomalies sur le réseau de distribution.

Le document US5568399A divulgue un procédé de détection d'anomalie sur un réseau de distribution électrique incluant une pluralité de nœuds consommateurs, chacun d'eux étant apte à transmettre des informations à une station de contrôle. Le procédé calcule des probabilités de localisation d'une faute par rapport à des dispositifs et également la probabilité agrégée, exécutant ainsi une comparaison avec un seuil préalable. Le document WO2015/092279A1 divulgue un procédé de détection d'anomalies dans un réseau en additionnant les signaux reçus des nœuds secondaires et en utilisant un algorithme pour calculer le comportement de certaines fonctions localisant ainsi l'anomalie. Le document US2014/278162A1 construit un réseau virtuel en utilisant la technique du mapping pour localiser les anomalies.

L'invention vient améliorer la situation.

Il est proposé un procédé de détection d'anomalie sur un réseau, mis en œuvre par ordinateur, incluant une pluralité de nœuds consommateurs, chacun des nœuds consommateurs étant apte à transmettre une confirmation via le réseau de distribution électrique en réponse à une requête reçue par l'intermédiaire du réseau de distribution électrique. Le procédé comprend :

   a) collecter les retours de requêtes transmises à chacun des nœuds consommateurs via le réseau de distribution électrique à une pluralité d'instants successifs d'une période d'observation et à une pluralité d'instants successifs d'une période courante,
   b) pour chaque requête, établir une variable d'état de type booléen dont la valeur correspond respectivement à la réception d'une confirmation ou à l'absence de réception d'une confirmation,
   c) pour chaque nœud consommateur et pour chacune des périodes, déduire une distribution statistique des transitions d'états possibles entre deux instants successifs,
   d) pour chaque nœud consommateur et pour chacune des périodes, calculer une vraisemblance de la distribution statistique,
   e) pour un ensemble de plusieurs nœuds consommateurs, calculer un indice d'écart à la normalité en fonction des vraisemblances de la période d'observation et de la période courante des nœuds consommateurs,
   f) comparer l'indice obtenu à une valeur seuil prédéfinie,
   g) uniquement dans le cas où l'indice obtenu dépasse la valeur seuil, générer un signal d'alerte.

Un tel procédé permet de détecter avec un haut degré de fiabilité des anomalies sur le réseau de de distribution électrique. Le compromis entre une détection d'un maximum d'anomalies et un minimum de fausses alertes est amélioré. En particulier, le procédé permet de distinguer un disfonctionnement réel du réseau de distribution d'un défaut de communication des nœuds consommateurs. Ainsi, la surveillance du réseau peut être en grande partie automatisée et réalisée sensiblement en continu. En cas de disfonctionnement, l'anomalie peut être détectée en temps réel et des mesures curatives peuvent être mises en œuvre au plus tôt. Les désagréments causés par un disfonctionnement sont de courte durée.

Selon un autre aspect, il est proposé un module de détection d'anomalie sur un réseau de distribution électrique comprenant une unité de traitement, le réseau incluant une pluralité de nœuds consommateurs, l'unité de traitement étant reliée au réseau et chacun des nœuds consommateurs étant apte à transmettre une confirmation via le réseau de distribution électrique en réponse à une requête reçue par l'intermédiaire du réseau de distribution électrique. L'unité de traitement est agencée de manière à :

a) interroger chacun des nœuds consommateurs via le réseau de distribution électrique à une pluralité d'instants successifs d'une période d'observation et à une pluralité d'instants successifs d'une période courante,
b) pour chaque interrogation, établir une variable d'état de type booléen dont la valeur correspond respectivement à la réception d'une confirmation ou à l'absence de réception d'une confirmation,
c) pour chaque nœud consommateur et pour chacune des périodes, déduire une distribution statistique des transitions d'états possibles entre deux instants successifs,
d) pour chaque nœud consommateur et pour chacune des périodes, calculer une vraisemblance de la distribution statistique,
e) pour un ensemble de plusieurs nœuds consommateurs, calculer un indice d'écart à la normalité en fonction des vraisemblances de la période d'observation et de la période courante des nœuds consommateurs,
f) comparer l'indice obtenu à une valeur seuil prédéfinie,
g) uniquement dans le cas où l'indice obtenu dépasse la valeur seuil, générer (113) un signal d'alerte.

Selon un autre aspect, il est proposé un programme d'ordinateur apte à être mis en œuvre en un procédé de détection d'anomalie sur un réseau tel que les procédés définis dans les présentes. Selon encore un autre aspect, il est proposé un support d'enregistrement non transitoire lisible par un ordinateur sur lequel est enregistré un programme comprenant des instructions pour la mise en œuvre d'un des procédés proposés dans les présentes.

Les caractéristiques suivantes peuvent, optionnellement, être mises en œuvre. Elles peuvent être mises en œuvre indépendamment les unes des autres ou en combinaison les unes avec les autres :

- L'indice d'écart à la normalité est équivalent à une somme ou une moyenne des différences de vraisemblances entre la période d'observation et la période courante de chaque nœud consommateur. Cela permet de détecter aisément et rapidement une anomalie touchant simultanément un nombre important de nœuds consommateurs sans pour autant déclencher de fausses alertes en cas de disfonctionnement limité à un unique nœud (anomalie probablement indépendante du réseau lui-même) ou de disfonctionnement à durée très courte par rapport à la période d'observation (anomalie à très faible durée pour laquelle déclencher une alerte est probablement inutile).

- Les interrogations et les réceptions de confirmations sont effectuées par Courtant Porteur en Ligne sur le réseau de distribution électrique. Ce type de communication ne nécessite ni d'installer un réseau de communication filaire dédié, ni de prévoir des communications sans fil. Les équipements physiques permettant la mise en œuvre de la communication par CPL sont parfois déjà installés ou en cours de déploiement. Ainsi, un réseau électrique existant peut être mis en conformité avec le procédé proposé ici par des mises à jour logicielles plus rapides et moins coûteuses que des installations physiques sur le terrain.

- La période d'observation est sélectionnée parmi plusieurs en fonction des conditions de fonctionnement du réseau de distribution électrique au cours de la période courante. Ainsi, les périodes d'observation peuvent être choisies analogues à la période courante de manière à limiter les biais contextuels dans les comparaisons. Par exemple, on peut considérer qu'il est préférable d'utiliser une période d'observation correspondant à une soirée d'hiver (consommation électrique élevée sur le réseau) pour comparer les comportements d'une période courante correspondant elle aussi à une soirée d'hiver.

- La période d'observation s'étend sur une durée comprise entre 1 seconde et 100 jours ; la période courante s'étend sur une durée comprise entre 10 millisecondes et 7 jours ; les instants successifs de l'une au moins de la période d'observation et de la période courante sont mutuellement espacés d'une durée comprise entre 1 milliseconde et 24 heures ; et/ou l'une au moins de la période d'observation et de la période courante comprend entre 2 et 500 instants successifs. D'après les essais de la demanderesse, de tels ordres de grandeur permettent de détecter la plupart des anomalies tout en présentant un faible taux de faux positifs.

- Les opérations sont mises en œuvre de manière répétée de sorte que les variable d'état relatives à la période courante sont mises à jour sensiblement en temps réel. Une surveillance en temps réel permet de générer un signal d'alerte rapidement après qu'une anomalie est survenue. Les délais d'interventions pour remédier aux anomalies s'en trouvent réduits.

- Les opérations sont mises en œuvre distinctement pour plusieurs ensembles de nœuds consommateurs d'un même réseau. Ceci permet, en cas d'alerte, non seulement une rapidité de la détection d'anomalie mais aussi une rapidité d'identification de l'origine de l'anomalie. L'efficacité des équipes d'intervention sur le terrain s'en trouve amélioré. En outre, les réponses à apporter aux anomalies peuvent être adaptées en fonction des nœuds consommateurs concernés, par exemple en fonction des activités humaines correspondant aux nœuds consommateurs (réseaux électriques domestiques, industriels ou d'importance vitale telle que les hôpitaux).

- La composition de chaque ensemble est sélectionnée en fonction des positions des nœuds consommateurs sur le réseau de sorte qu'un signal d'alerte est associé à une zone prédéfinie du réseau. Ceci permet aussi, en cas d'alerte, d'identifier rapidement l'origine de l'anomalie.

D'autres caractéristiques, détails et avantages de l'invention apparaîtront à la lecture de la description détaillée ci-après, et à l'analyse des dessins annexés, sur lesquels :

- la figure 1 est une représentation schématique d'un réseau à surveiller ;
- la figure 2 représente les données brutes résultant d'une surveillance d'un ensemble de nœuds pendant une période commune ;
- la figure 3 est un diagramme représentant différentes opérations mises en œuvre selon l'invention et sous la forme d'une boucle itérative ;
- la figure 4 représente les données brutes résultant d'une surveillance de deux nœuds pendant une période commune ;
- la figure 5 représente les données brutes résultant d'une surveillance d'un ensemble de nœuds pendant une période commune réelle ;
- la figure 6 est une représentation analogue à celle de la figure 5 d'une surveillance pendant laquelle des anomalies sont simulées ;
- la figure 7 représente l'évolution comparée d'un indice calculé selon deux modes de réalisation à partir des données de la surveillance représentée en figure 6 ; et
- la figure 8 représente l'évolution du taux de détection des anomalies en fonction du nombre de fausses alarmes selon quatre méthodes distinctes.

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

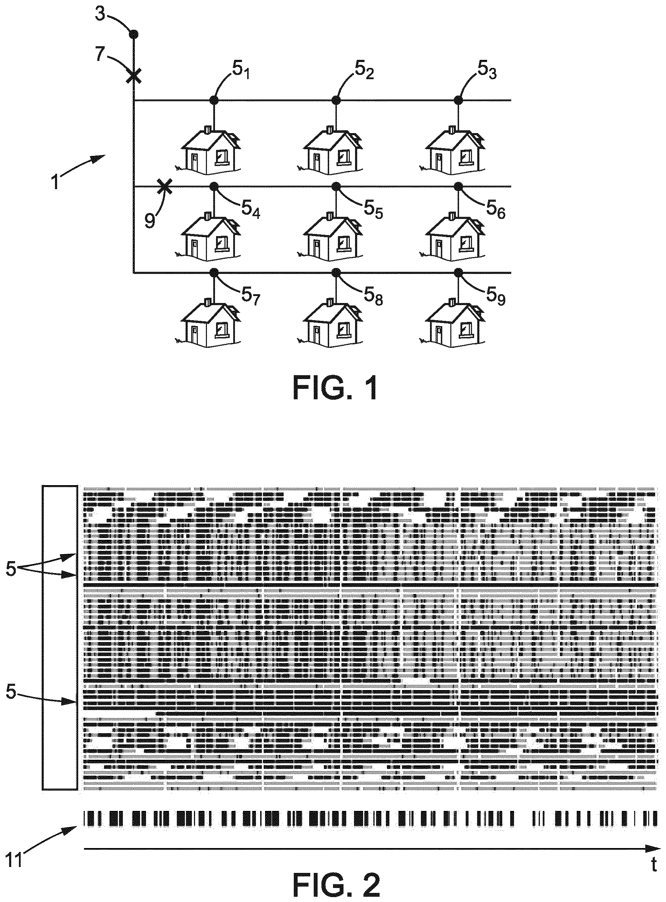

En figure 1, un réseau 1 de distribution d'électricité est représenté. Le réseau 1 comprend un nœud source 3 et une pluralité de nœuds consommateurs $5_i$, l'indice i permettant de distinguer les nœuds consommateurs 5 les uns des autres. Dans l'exemple décrit ici, le réseau 1 comprend neuf nœuds $5_i$ répartis en trois groupes de trois nœuds.

Dans l'exemple décrit ici, un nœud source 3 correspond à un transformateur disposé entre le réseau de transport moyenne tension (ou haute tension type A HTA) et le réseau de distribution basse tension (BT) en aval. Le réseau Basse Tension (BT) choisi en exemple présente une structure arborescente. Le sommet de la structure arborescente correspond au nœud source 3, matérialisé ici par un poste de transformation HTA/BT. Chaque nœud consommateur 5 forme un point de branchement le long d'un des tronçons du réseau 1.

Les nœuds consommateurs 5 correspondent sensiblement aux « Point De Livraison (PDL) ». Chaque nœud consommateur 5 forme une interface entre le réseau 1 et un réseau électrique secondaire, généralement privé. En pratique, le nœud consommateur 5 est matérialisé par un ensemble d'équipements, dont un compteur propre à comptabiliser la consommation électrique du réseau secondaire à des fins de facturation. Par abus de langage, les nœuds consommateurs 5 peuvent être appelés compteurs.

Dans le présent contexte, des anomalies 7, 9 se produisent sur le réseau 1. L'anomalie 7 a lieu immédiatement en aval du nœud source 3 et en amont des bifurcations du réseau 1. L'anomalie 7 entraîne une interruption de la fourniture d'énergie de tous les nœuds 5 du réseau 1. L'anomalie 9 a lieu en aval d'une des bifurcations du réseau 1. L'anomalie 9 entraîne une interruption de la fourniture d'énergie de certains seulement des nœuds 5 du réseau 1, ici les nœuds $5_4$, $5_5$ et $5_6$.

Dans les modes de réalisation décrit ci-après, le procédé permet de détecter une anomalie 7, 9 ayant pour conséquence l'interruption de la fourniture d'électricité de certains au moins des nœuds consommateurs 5 du réseau 1. Le procédé permet de détecter la survenance d'au moins une anomalie 7, 9 sans nécessairement en identifier la source ou la partie du réseau 1 concernée.

Dans des modes de réalisation particuliers, le procédé permet non seulement de détecter la survenance d'une anomalie 7, 9 mais permet en outre d'en identifier certaines au moins des caractéristiques, par exemple les parties du réseau 1 concernées. Dans ce dernier cas, les précisions de localisation permettent d'adapter en conséquence les mesures curatives à mener et donc de réduire encore les durées d'interruption de la fourniture d'énergie pour les nœuds consommateurs 5 impactés.

Sur le réseau 1, chacun des nœuds consommateurs 5 est équipé d'un module de communication, ou interface de communication, apte à transmettre des données vers un concentrateur commun. Chacun des nœuds consommateurs 5 est apte à transmettre, au moins, une confirmation via le réseau 1 de distribution électrique en réponse à une requête reçue par l'intermédiaire du réseau 1 de distribution électrique. Chaque nœud consommateur 5 est communicant. Par exemple, les compteurs intelligents ou AMM pour « *Automated Meter Management* » sont aptes à échanger des données avec le concentrateur. Le concentrateur collecte les données de plusieurs AMM. Le concentrateur est, par exemple, situé au niveau du nœud source 3.

Dans l'exemple décrit ici, le concentrateur transmet à son tour des informations à une unité de traitement distante et commune à plusieurs concentrateurs, par exemple via un réseau de téléphonie mobile. Ainsi, l'unité de traitement de données comprend un processeur couplé de manière opérationnelle avec une mémoire pour mettre en œuvre au moins en partie un procédé tel que défini dans les présentes. En variante, une partie au moins du traitement des données peut être mis en œuvre par les concentrateurs et/ou localement par des équipements voisins des concentrateurs.

Parmi les AMM développés, certains comprennent des modules de communication fonctionnant par Courant Porteur en Ligne (CPL). Ainsi, les données sont échangées par le réseau électrique lui-même sans qu'il soit nécessaire de prévoir un réseau de communication dédié entre le concentrateur et les nœuds consommateurs 5. Le réseau de communication utilise physiquement le réseau câblé électrique.

Parmi les protocoles de communication CPL, certains se composent d'un terminal maître (ici le concentrateur) et de plusieurs terminaux esclaves (ici les modules de communication des nœuds consommateurs 5). L'ensemble des terminaux, ou nœuds, est parfois appelé « grappe CPL ». Contrairement à d'autres configurations connues, une telle configuration maître-esclave ne permet pas aux nœuds consommateurs 5 de transmettre activement un signal d'alerte au concentrateur pour indiquer une perte d'alimentation. Les modules de communication des nœuds consommateurs 5 sont généralement alimentés en énergie par le réseau de distribution lui-même. Par conséquent, les nœuds consommateurs 5 cessent de fonctionner (et de transmettre des données) lorsque la fourniture d'énergie est interrompue.

Dans de premiers essais, la demanderesse a tenté d'interpréter l'absence de communication de certains nœuds consommateurs 5 détectée depuis le concentrateur comme un indicateur d'une anomalie. Cette approche est représentée en figure 2.

Le concentrateur interroge chacun des nœuds consommateurs 5 par une requête. Lorsqu'il est en mesure de le faire, le nœud consommateur 5 répond par une confirmation. Pour chaque requête, le concentrateur reçoit donc une confirmation ou ne reçoit pas de confirmation. La réception d'une confirmation est notée « OK » ci-après et représentée par un remplissage grisé sur les figures 2 et 4 à 6. L'absence de confirmation est notée « KO » ci-après et représentée par un remplissage noir sur les figures 2 et 4 à 6. Dans les exemples décrits ici, la requête et la confirmation attendue, à l'image d'une commande «ping», sont dépourvues d'autre information. Ainsi, la consommation énergétique d'un tel fonctionnement et les risques d'anomalie de communication sont réduits. En variante, l'opération d'interrogation par le concentrateur et de réponse par chaque nœud consommateur 5 peut être combinée à d'autres opérations de communication. Par exemple, une requête du concentrateur peut viser à relever une consommation sur le nœud consommateur 5. La réponse du nœud consommateur 5, respectivement l'absence de réponse, peut être interprétée comme une confirmation OK, respectivement une absence de confirmation KO.

Dans l'essai représenté en figure 2, chacun des nœuds consommateurs 5 d'un ensemble (ou grappe) est interrogé par un concentrateur via un réseau 1 commun de distribution électrique. Les requêtes/interrogations sont effectuées, pour chacun des nœuds consommateurs 5, à intervalles réguliers. En figure 2, l'abscisse correspond au temps tandis que chacune des lignes de la partie supérieure correspond à un nœud consommateur 5. Les confirmations reçues (OK) sont représentées en grisé. Les absences de confirmation (KO) sont représentées en noir. Les absences d'information sont représentées en blanc.

Dans un premier essai, il a été choisi arbitrairement que l'absence de confirmation (KO) d'au moins 20 nœuds consommateurs 5 par intervalle entraîne l'émission d'une alerte 11. En partie inférieure de la figure 2, les alertes 11 émises au cours du temps sont représentées par du noir, tandis que l'absence d'alerte est représentée par du blanc. Durant cet essai, aucune anomalie d'alimentation n'a eu lieu sur le réseau 1 pendant la période étudiée. Toutes les alertes sont donc, ici, de fausses alertes.

Dans cet exemple, les absences de confirmation KO sont dues à d'autres raisons que des interruptions d'alimentation des nœuds consommateurs 5. Les absences de confirmation KO sont manifestement dues à des problèmes propres à la communication. En effet, le réseau 1 est, par nature, conçu pour transporter de l'énergie électrique et pas des données. La technologie du CPL est imparfaite : des erreurs de communication sont fréquentes. Par exemple, les charges connectées au réseau de distribution peuvent provoquer des atténuations du signal CPL ou générer des bruits parasites dans les bandes de fréquences utilisées pour les émissions CPL. La qualité des communications CPL peut évoluer dans le temps en fonction des conditions d'utilisation du réseau électrique. De plus, de telles perturbations sont souvent géographiquement hétérogènes : les communications avec les nœuds consommateurs 5 sont perturbées différemment en fonction de l'emplacement des nœuds consommateurs 5 sur le réseau 1. En outre, les modules de communication présents au niveau des nœuds consommateurs 5 sont prévus initialement pour assurer des services de relève (pour la facturation), pour programmer les grilles tarifaires et pour mettre à jour les composants logiciels. Pour assurer de telles fonctions, il est généralement admis qu'un taux de réponse du module de communication de 90% est suffisant. Les modules de communication installés ou en cours de déploiement sont donc prévus pour une telle performance. Par conséquent, en fonctionnement normal, il est beaucoup plus probable qu'une absence de confirmation KO résulte d'une erreur de communication plutôt que d'une interruption de la fourniture d'énergie du nœud consommateur 5.

Ainsi, la méthode décrite jusqu'ici ne donne pas entièrement satisfaction, pour au moins les trois raisons suivantes :

- la probabilité d'un échec de communication est bien plus élevée que la probabilité d'une interruption de l'alimentation électrique ;
- la qualité des communications varie d'un nœud consommateur 5 à l'autre ; et
- la qualité des communications des nœuds consommateurs5 varie dans le temps.

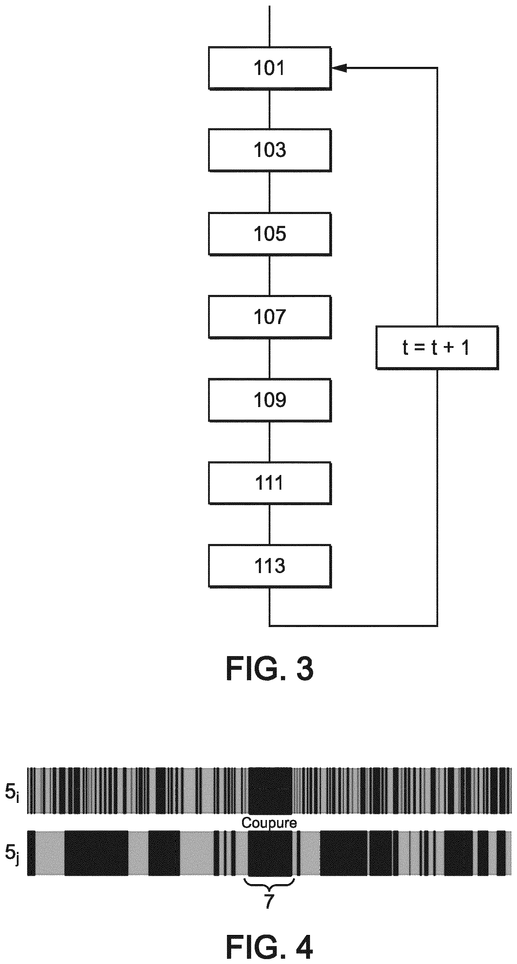

Il est maintenant fait référence à la figure 3.

Chacun des nœuds consommateurs 5 est interrogé via le réseau 1 de distribution électrique. Les interrogations sont répétées à une pluralité d'instants t successifs d'une période d'observation T (ou d'apprentissage) et à une pluralité d'instants t' successifs d'une période courante T'. Dans l'exemple décrit ici, le concentrateur émet des requêtes à destination de chacun des nœuds consommateurs 5. Les interrogations et les réceptions de confirmation OK sont effectuées via le réseau 1 lui-même, ici au moyen de CPL. Dans l'exemple décrit ici, une requête spécifique est envoyée à chaque nœud consommateur 5. Un tel fonctionnement est, par exemple, compatible avec le protocole de communication par CPL normé et connu sous la référence « G1 ».

En variante, une requête générale à tous les nœuds peut être transmise (type « *broadcast* »). Le retour de chaque nœud 5, c'est-à-dire la réponse ou l'absence de réponse, est ensuite répertoriée. L'état des nœuds (OK ou KO) peut aussi être déduit en fonction de l'existence d'une réponse ou de l'absence de réponse à tout type de requêtes, notamment des requêtes non spécifiquement dédiées à la mise en œuvre du présent procédé.

Les retours de plusieurs nœuds peuvent être au moins en partie regroupés dans des ensembles de données stockés dans une mémoire. Un tel fonctionnement est, par exemple, compatible avec le protocole de communication par CPL normé et connu sous la référence «G3». Selon ce protocole, les retours des nœuds peuvent être transmis indirectement de nœuds en nœuds, par exemple au moyen d'ensemble de données de type « table de voisins ».

En réponse à chaque requête, une réponse/confirmation est reçue ou rien n'est reçu. Dans une première opération 101, les retours des requêtes sont collectés et répertoriés. À réception de la confirmation ou à non réception de la confirmation, une deuxième opération 103 est mise en œuvre : il est établi une variable d'état $B_{i,t}$ de type booléen dont la valeur correspond respectivement à la réception d'une confirmation (OK) ou à l'absence de réception d'une confirmation (KO).

La période d'observation T est choisie comme une référence. La période d'observation T est sélectionnée pour être représentative du fonctionnement normal des communications entre les nœuds consommateurs 5 et le concentrateur en l'absence d'anomalie d'alimentation sur le réseau 1.

La période courante T' correspond à la période pour laquelle on souhaite identifier l'existence éventuelle d'anomalies. Lorsque le procédé est mis en œuvre dans le cadre d'une surveillance en temps réel du réseau 1, la période courante T' correspond au temps réel de la surveillance tandis que la période d'observation T correspond à une période antérieure pour laquelle les résultats de la deuxième opération 103 ont été préalablement enregistrés. Par exemple, la première opération 101 et la deuxième opération 103 sur la période d'observation T peuvent être réalisées avant que la première opération 101 et la deuxième opération 103 ne soient réalisées sur la période courante T'. Les résultats de la deuxième opération 103 menée sur une période d'observation T peuvent être mémorisés. Puis, dans un second temps, la première opération 101 et la deuxième opération 103 sont mises en œuvre sur la période courante T'.

La période d'observation T peut être sélectionnée parmi plusieurs périodes d'observations en fonction des conditions de fonctionnement du réseau 1 au cours de la période courante T'. Par exemple, la période d'observation T est sélectionnée de sorte que les conditions d'utilisation du réseau 1 soient équivalentes à celles de la période courante T'. Si on souhaite surveiller le réseau 1 lorsque les consommations sont élevées et le réseau électrique fortement sollicité (par exemple le soir en hiver), on peut sélectionner une période d'observation T correspondant à un soir d'hiver antérieur. Ainsi, l'influence des variations temporelles de la qualité des communications sur les résultats du procédé est réduite. Dans des modes de réalisation, par exemple pour une surveillance en temps réel, la période d'observation T peut être glissante. La période d'observation T peut être sélectionnée immédiatement antérieure à la période courante T' de sorte les conditions d'utilisation du réseau restent similaires et comparables entre la période d'observation T et la période courante T'.

Le procédé peut être mis en œuvre de manière répétée, notamment en continu pour une surveillance en temps réel. Dans ces cas, les résultats obtenus sur une période courante T' peuvent être mémorisés. Si la période courante T' ne comporte aucune anomalie d'alimentation électrique, elle peut devenir une période d'observation T pour une itération ultérieure du procédé.

Pour faciliter la compréhension, les opérations sont présentées comme se déroulant les unes à la suite des autres. En variante, les opérations de collecte 101 des retours des nœuds et d'attribution 103 des variables d'état B sont mises en œuvre préalablement. Les données qui en résultent peuvent être stockées au moins temporairement. Puis, les opérations suivantes de traitement des données peuvent être mises en œuvre dans un deuxième temps.

Dans une troisième opération 105, pour chaque nœud consommateur 5 et pour chacune des périodes T, T', il est déduit une distribution statistique $P_i$, $P'_i$ des transitions d'états possibles (OK→OK, OK→KO, KO→OK, KO→KO) entre les instants t successifs de ladite période T, respectivement T'.

Au cours de la troisième opération 105, la succession des transitions entre deux variables d'état $B_{i,t}$ $B_{i,t+1}$ peut être modélisée sous la forme d'une chaîne de Markov à deux états OK, KO pour chaque nœud consommateur $5_i$ en considérant que l'état à un instant est indépendant de l'état de l'instant précédent. Avec deux variables d'états OK et KO, il existe donc quatre transitions possibles : (OK→OK), (OK→KO), (KO→OK), et (KO→KO).

Par exemple, on considère la séquence suivante d'un nœud consommateur 5 :

OK → KO → OK → OK→ KO → KO → OK → KO → KO → KO → KO

Dans cet exemple, le comptage des transitions ($B_x$→$B_y$) possibles de variables d'état $B_i$ est le suivant :

$$\begin{cases} Nb(OK \rightarrow OK) = 1 \\ Nb(OK \rightarrow KO) = 3 \\ Nb(KO \rightarrow KO) = 4 \\ Nb(KO \rightarrow OK) = 2 \end{cases}$$

La distribution statistique des transitions possibles peut aussi prendre la forme d'une matrice de transition. Par exemple, les lignes correspondent à l'état à un instant t et les colonnes à l'état à l'instant suivant t+1. Les éléments de cette matrice représentent l'ensemble des probabilités P de transition d'un état vers un autre. Une telle matrice peut se calculer de la manière suivante :

$$\begin{cases} P(OK \rightarrow OK) = \dfrac{Nb(OK \rightarrow OK)}{Nb(OK \rightarrow OK) + Nb(OK \rightarrow KO)} \\ P(OK \rightarrow KO) = \dfrac{Nb(OK \rightarrow KO)}{Nb(OK \rightarrow OK) + Nb(OK \rightarrow KO)} \\ P(KO \rightarrow KO) = \dfrac{Nb(KO \rightarrow KO)}{Nb(KO \rightarrow KO) + Nb(KO \rightarrow OK)} \\ P(KO \rightarrow OK) = \dfrac{Nb(KO \rightarrow OK)}{Nb(KO \rightarrow KO) + Nb(KO \rightarrow OK)} \end{cases}$$

Avec l'exemple de séquence ci-avant, on obtient les probabilités de transition suivantes :

$$P(OK \rightarrow OK) = \frac{1}{4}$$

$$P(OK \rightarrow KO) = \frac{3}{4}$$

$$P(KO \rightarrow KO) = \frac{4}{6}$$

$$P(KO \rightarrow OK) = \frac{2}{6}$$

La matrice de transition prend donc la forme suivante :

$$M = \begin{matrix} & OK & KO \\ OK & 0.25 & 0.75 \\ KO & 0.33 & 0.67 \end{matrix}$$

Dans une quatrième opération 107, pour chaque nœud consommateur 5, la vraisemblance $L_i$, respectivement $L_i'$, des transitions de la période courante T' est calculé en fonction de la distribution statistique $P_i$ pendant la période d'observation T, respectivement en fonction de la distribution statistique $P_i'$ pendant la période courante T'.

Le calcul de la vraisemblance $L_i$ par rapport à la distribution statistique $P_i$ pendant la période d'observation T permet de détecter un comportement inhabituel du nœud 5. Ainsi, en fonction du comportement habituel en communication du nœud 5, il est possible d'estimer la pertinence potentielle des défauts de réponse (KO) futurs pour déduire une anomalie d'alimentation.

Le calcul de la vraisemblance $L_i'$ par rapport à la distribution statistique $P_i'$ pendant la période courante T' permet de quantifier la variabilité des dernières transitions d'un nœud consommateur 5 au cours de la période courante T'. Le calcul de $L_i'$ permet de quantifier la prédictibilité, c'est-à-dire le caractère stochastique de la succession des dernières transitions présumée être un processus Markovien par comparaison avec le comportement du nœud consommateur 5 durant cette même période courant T', et ce indépendamment du comportement des autres nœuds consommateurs 5. Ainsi, on peut distinguer, au sein de la période courante T', un comportement erratique (très bref donc probablement non représentatif) d'un comportement significatif sur la période courante T' (donc probablement représentatif). Cette quantification est indépendante du comportement des autres nœuds consommateurs 5.

Un exemple de calcul de la vraisemblance $L_i$, $L_i'$ de la distribution statistique $P_i$, $P_i'$ est décrit ci-après. Des calculs de vraisemblance différents peuvent être mis en œuvre pour mesurer les mêmes aspects.

La vraisemblance $L_i$ par rapport à la période d'observation T est calculée selon l'équation suivante :

$$L_i = \frac{1}{N_{eval}} \sum_{x,y} Nb_{T'}(B_x \rightarrow B_y) \times \log(P_i(B_x \rightarrow B_y))$$

avec

i, l'indice identifiant le nœud consommateur 5,
$N_{eval}$ le nombre total de transitions observées pendant une séquence d'évaluation de la période courante T',
$Nb_{T'}(B_x \rightarrow B_y)$ le nombre de transitions de type $B_x \rightarrow B_y$ observées pendant la période courante T', et
$P_i(B_x \rightarrow B_y)$ la probabilité d'observer la transition de type $B_x \rightarrow B_y$ pendant la période d'observation T,
l'ensemble des transitions de variables d'état possibles correspondant ici aux quatre transitions possibles : (OK→OK), (OK→KO), (KO→OK), et (KO→KO).

La vraisemblance $L_i'$ par rapport à la période courante T' de la séquence d'évaluation est calculée selon l'équation suivante :

$$L_i' = \frac{1}{N_{eval}} \sum_{x,y} Nb_{T'}(B_x \rightarrow B_y) \times \log(P_i'(B_x \rightarrow B_y))$$

avec $P_i'(B_x \rightarrow B_y)$ la probabilité d'observer la transition de type $B_x \rightarrow B_y$ pendant la période courante T'.

Dans cet exemple, le facteur $1/N_{eval}$ permet de moyenner la vraisemblance sur le nombre de transitions de la séquence d'évaluation de sorte que le résultat est rendu moins dépendant de la longueur de la séquence d'évaluation.

Dans une opération 109, pour un ensemble de plusieurs nœuds consommateurs 5, un indice S (ou score) d'écart à la normalité est calculé en fonction des vraisemblances $L_i$, $L'_i$ par rapport à la période d'observation T et par rapport à la période courante T' de chaque nœud consommateur 5. L'indice S peut s'exprimer, par exemple, sous la forme d'une différence telle que dans l'équation suivante :

$$S = \sum_i L'_i - L_i$$

Pour chaque nœud consommateur $5_i$,

- plus les transitions d'état de la séquence d'évaluation sont vraisemblables dans le contexte de la période courante, c'est-à-dire conformes au comportement récent du nœud consommateur $5_i$, et
- moins les transitions d'état de la période d'observation T sont vraisemblables par rapport au comportement passé, c'est-à-dire peu conformes au comportement habituel du nœud consommateur $5_i$,
- plus l'indice S est élevé.

Ainsi, l'indice S est particulièrement élevé lorsqu'est observé une combinaison de :

- un comportement non transitoire (ou stable) à l'échelle de la période d'évaluation (comparaison court terme), et
- un comportement anormal par rapport à un comportement de référence observé lors d'une période comparable antérieure (comparaison à long terme).

Dans le cadre spécifique des communications des nœuds consommateurs 5, l'indice S peut subir une opération optionnelle de correction. Par exemple, l'indice S prend la forme d'une moyenne (ou somme) dont les éléments relatifs à des nœuds 5 particuliers sont ignorés, par exemple pour supprimer ou atténuer les effets dans la détection d'anomalies de nœuds présentant des comportements aberrants ou dont les disfonctionnements sont connus et traités par ailleurs.

Dans une opération 111, l'indice S ou l'indice corrigé $S_{cor}$ obtenu est comparé à une valeur seuil $S_{ref}$ prédéfinie.

Dans une opération 113, un signal d'alerte est généré uniquement dans le cas où l'indice S (ou $S_{cor}$) obtenu dépasse la valeur seuil $S_{ref}$.

La figure 4 représente les réponses (ou l'absence de réponse) au cours du temps de deux nœuds consommateurs $5_i$, $5_j$ disposés sur un réseau 1 commun. Les deux nœuds consommateurs $5_i$, $5_j$ ont été sélectionnés de sorte qu'ils présentent un taux de réponse identique sur la période de temps observée. Autrement, dit la qualité de leur communication est, en valeur globale, identique. Une unique anomalie d'alimentation électrique 7 a eu lieu pendant la période d'observation. Or, on constate sur la figure 4 que la succession d'absences de réponse KO (en noir) correspondant à l'anomalie 7 est plus aisément identifiable sur le chronogramme du nœud consommateur $5_i$ que sur le chronogramme du nœud consommateur $5_j$. Autrement dit, bien que les deux nœuds consommateurs $5_i$, $5_j$ présentent des taux de réponse identiques, il est plus facile de distinguer une anomalie d'alimentation à partir des erreurs de communication sur l'un des nœuds consommateurs que sur l'autre.

Le nœud $5_i$ de la figure 4 présente une répartition des erreurs de communication homogène dans le temps. L'alternance de réponses OK et d'absences de réponse KO est rapide. Ainsi, il semble aisé de repérer une succession d'absences de réponse KO correspondant à une anomalie d'alimentation et présentant une longue durée parmi les brèves successions d'absences de réponse KO dues aux erreurs de communication. Par comparaison, le nœud $5_j$ de la figure 4 présente une répartition des erreurs de communication hétérogène dans le temps, avec de longues successions d'absences de réponse KO. Ainsi, il semble difficile de distinguer une succession d'absences de réponse KO correspondant à une anomalie d'alimentation d'une succession d'absences de réponse KO correspondant à des erreurs de communication.

Les matrices de transition des nœuds $5_i$ et $5_j$ de la figure 4 sont reproduites ci-dessous :

$$M_i = \begin{array}{c} \\ OK \\ KO \end{array} \begin{array}{cc} OK & KO \\ 0{,}45 & 0{,}55 \\ 0{,}45 & 0{,}55 \end{array}$$

$$M_j = \begin{array}{c} \\ OK \\ KO \end{array} \begin{array}{cc} OK & KO \\ 0,9 & 0,1 \\ 0,1 & 0,9 \end{array}$$

Les deux matrices amènent le constat suivant : les probabilités d'aller vers l'état KO (événement se produisant en cas de coupure d'alimentation) diffèrent entre les deux nœuds consommateurs $5_i$ et $5_j$. Pour le second nœud $5_j$, les probabilités d'atteindre l'un ou l'autre des deux états est fortement dépendant de l'état précédent. Le procédé décrit ci-avant mesure cette dépendance au moyen de l'analyse statistique et l'utilise pour distinguer les nœuds en fonction de leur pertinence. L'observation d'une transition est d'autant plus pertinente qu'elle est singulière (probabilité d'occurrence faible).

L'exemple de la figure 4 illustre l'approche proposée par la demanderesse.

L'indice S tel que décrit ci-avant permet une analyse combinée du comportement statistique court terme et long terme de chaque nœud consommateur indépendamment les uns des autres. Le procédé permet de distinguer les comportements anormaux mais transitoires des comportements anormaux et durables à l'échelle de la période d'observation. Par construction de l'indice S, les bruits statistiques sont éliminés de l'analyse, ce qui permet de limiter le taux de faux positifs (fausse alarme).

En outre, l'analyse statistique est effectuée distinctement sur chaque nœud consommateur 5, ce qui permet de réduire les effets des différences intrinsèques des nœuds consommateurs 5 les uns par rapport aux autres, notamment en terme de performance en communication. Le calcul final de l'indice S agrégé sur un ensemble de plusieurs nœuds consommateurs 5 permet de faire ressortir des anomalies faibles au niveau de chacun des nœuds consommateurs 5 mais simultanées. La remise à zéro en cas de réception de confirmation (OK) permet d'éliminer l'impact des séquences dépourvues de confirmations (KO) entrecoupées de confirmation (OK), c'est-à-dire du bruit ne correspondant manifestement pas à une coupure de l'alimentation du nœud consommateur 5.

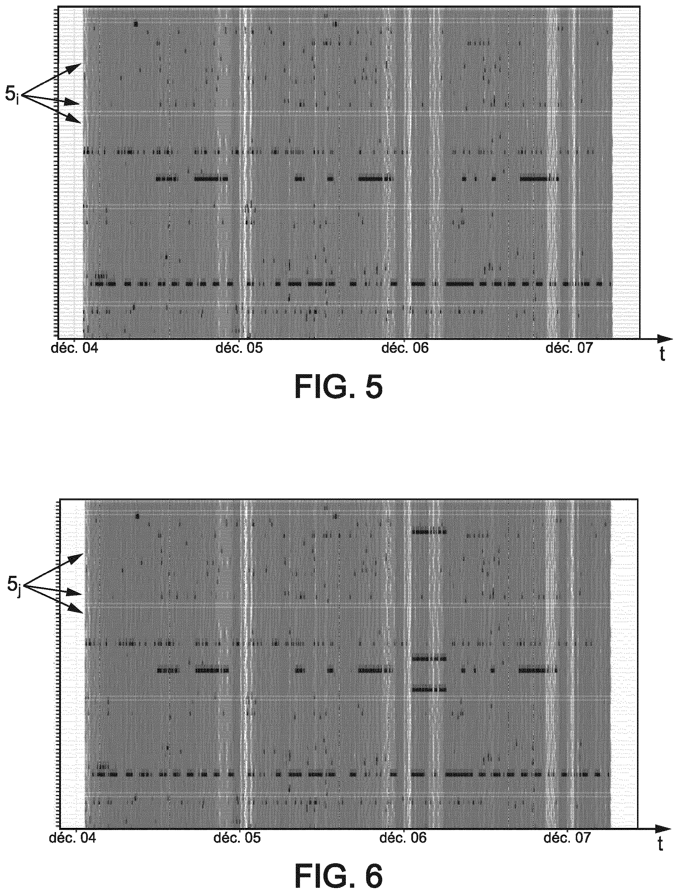

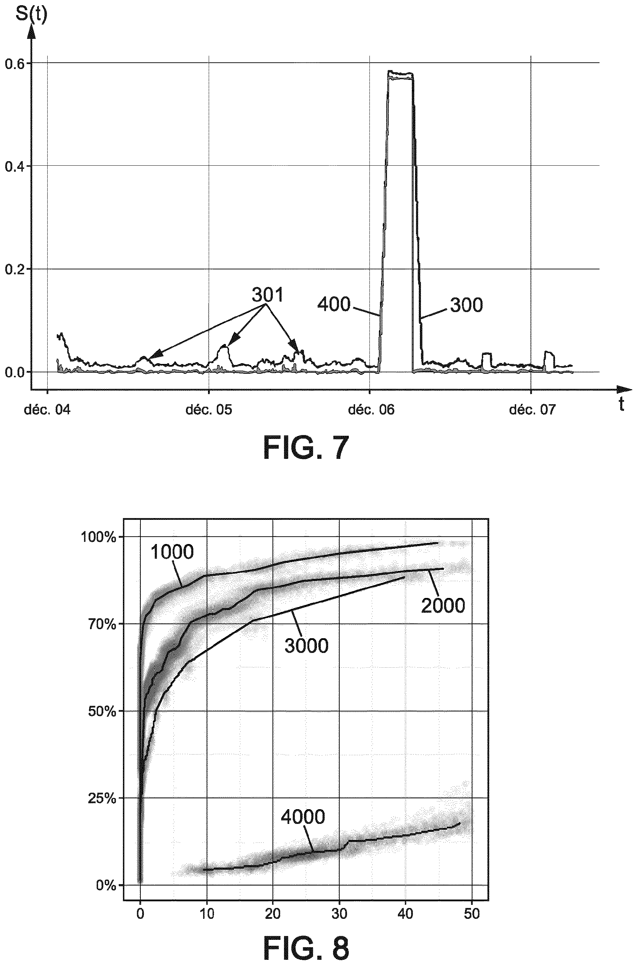

La figure 5 montre un relevé de données dans des conditions réelles et en l'absence d'anomalie sur une pluralité de nœuds consommateurs 5, chaque nœud correspondant à une ligne, au cours du temps représenté en abscisse. La figure 6 montre les mêmes données que pour la figure 5 à ceci près qu'une coupure d'alimentation est simulée sur certains nœuds consommateurs 5. La figure 7 représente l'évolution de l'indice mesuré selon le procédé décrit ci-avant au cours du temps à partir des données représentées en figures 6. La courbe 300 correspond à la valeur de l'indice S sans correction tandis que la courbe 400 correspond à la valeur de l'indice $S_{cor}$ après correction.

On constate que chacun des deux procédés permet d'identifier sans ambiguïté la période concernée par une anomalie alors même qu'une faible part des nœuds 5 est concernée par la coupure d'alimentation.

En outre, l'application de la correction permet de faire disparaître certaines variations 301 non pertinentes et visibles sur la courbe 300.

La figure 8 représente le taux de détection de coupures (en ordonnée et en pourcentage) en fonction du nombre de faux positifs (en abscisse et en nombre par semaine d'un ensemble de nœuds test). Quatre méthodes sont comparées.

Une première méthode, correspondant à la courbe référencée 4000, consiste à dénombrer à chaque instant t le nombre de nœuds consommateurs 5 pour lesquels une absence de confirmation (KO) est observée et de déclencher une alerte au-dessus d'une valeur seuil. Cela correspond à la méthode présentée ci-avant en référence à la figure 2.

Une deuxième méthode, correspondant à la courbe référencée 3000, consiste à dénombrer à chaque instant t le nombre d'absences de confirmation (KO) et de déclencher une alerte au-dessus d'une valeur seuil en excluant du compte les nœuds présentant un taux général de réponse trop faible (technique de « liste noire »).

La courbe référencée 2000 correspond à un mode de réalisation du procédé, en l'absence de correction de l'indice S.

La courbe référencée 1000 correspond à un mode de réalisation du procédé, avec application de la correction de l'indice $S_{cor}$.

Les essais comparatifs de la figure 8 ont été menés dans les conditions suivantes :

- panel de 103 nœuds consommateurs communiquant par CPL (sous protocole «G1») sélectionnés parmi des nœuds fonctionnant en conditions réelles dans le contexte du déploiement des compteurs « Linky » en France ;
- les procédés correspondant aux courbes 1000 et 2000 ont été mis en œuvre par ordinateur, ici par implémentation dans un logiciel d'un concentrateur ;
- les requêtes sont espacées d'un intervalle constant et supérieur à une seconde ;
- les calculs sont effectués de manière itérative en temps réel ;
- la période d'observation T correspond aux 15 jours précédents la période courante T' et aux données enregistrées distinctement pour chaque nœud. La période d'observation T est donc, ici, glissante dans le temps ;
- la séquence d'évaluation est définie comme la suite des 15 dernières transitions ($N_{eval} = 15$) pour chaque noeud ;
- les coupures d'alimentation sont simulées par l'attribution artificielle de la valeur «KO» à la variable d'état $B_{i,t}$ d'un sous ensemble de nœuds pendant une période commune (passage des données brutes réelles de la figure 5 à celles simulées de la figure 6).

Les courbes de la figures 8 sont obtenues en faisant varier le seuil de déclenchement pour les deux premières méthodes, respectivement la valeur de référence $S_{ref}$ pour les deux procédés de traitement statistique. Les marges d'erreur du redressement sont calculées par inférence statistique (« *bootstrap* ; ré-échantillonnage des ensembles de nœuds avec 1000 itérations).

Un exemple de résultat comparé est donné dans le tableau suivant en fixant le nombre de fausses alarmes par semaine à dix :

| Méthode | Taux de détection |
|---|---|
| Comptage KO (courbe 4000) | 4,60 % |
| Comptage KO avec liste noire (courbe 3000) | 63,8 % |
| Indice statistique sans correction (courbe 2000) | 77,1 % |
| Indice statistique avec correction (courbe 1000) | 88,1 % |

Réciproquement, le tableau suivant donne un nombre de fausses alarmes (par grappe et par semaine) pour un taux de détection des anomalies fixé à 50% :

| Méthode | Nombre de fausses alarmes |
|---|---|
| Comptage KO | 110 |
| Comptage KO avec liste noire | 3,76 |
| Score statistique sans correction | 0,625 |
| Score statistique avec correction | 0,00305 |

Le procédé du score statistique avec correction comparé à la méthode du simple comptage des absences de réponses (KO) permet donc de diminuer le nombre de fausses alarmes par un facteur 36 000 tout en conservant le même taux de détection.

Quel que soit le compromis choisi entre taux de détection et fausse alarme par réglage du seuil de déclenchement, les procédés proposés ici permettent d'améliorer significativement la situation par rapport à une surveillance par comptage, avec ou sans application d'une liste noire. Les techniques de liste noire, bien que permettant de réduire le nombre de fausse alarme, conduisent souvent à ignorer une partie du réseau, ce qui n'est pas souhaitable.

Dans des variantes, le procédé peut être appliqué en parallèle sur plusieurs groupes de nœuds 5 d'un même réseau 1. Les groupes peuvent être complètement distincts ou bien comprendre des nœuds 5 communs. La composition de chaque ensemble peut être sélectionnée en fonction des positions des nœuds consommateurs 5 sur le réseau 1 de sorte qu'un signal d'alerte est associé à une zone prédéfinie du réseau 1. Ainsi, lorsqu'une alerte est générée pour un groupe, le signal peut être associé à une zone du réseau 1.

L'invention ne se limite pas aux exemples de procédé et de système décrits ci-avant, seulement à titre d'exemple, mais elle englobe toutes les variantes que pourra envisager l'homme de l'art dans le cadre de la protection recherchée, qui est définie par les revendications.

**Revendications**

**1.** Procédé mis en œuvre par ordinateur de détection d'anomalie sur un réseau (1) de distribution électrique incluant une pluralité de nœuds consommateurs (5), chacun des nœuds consommateurs (5) étant apte à transmettre une confirmation via le réseau (1) de distribution électrique en réponse à une requête reçue par l'intermédiaire du réseau (1) de distribution électrique, le procédé comprenant :

a) collecter (101) les retours de requêtes transmises à chacun des nœuds consommateurs (5) via le réseau (1) de distribution électrique à une pluralité d'instants (t) successifs d'une période d'observation (T) et à une pluralité d'instants (t') successifs d'une période courante (T'),

b) pour chaque requête, établir (103) une variable d'état ($B_{i,t}$) de type booléen dont la valeur correspond respectivement à la réception d'une confirmation (OK) ou à l'absence de réception d'une confirmation (KO),

c) pour chaque nœud consommateur (5) et pour chacune des périodes (T, T'), déduire (105) une distribution statistique ($P_i$, $P'_i$) des transitions d'états possibles (OK→OK, OK→KO, KO→OK, KO→KO) entre deux instants successifs,

d) pour chaque nœud consommateur (5) et pour chacune des périodes (T, T'), calculer (107) une vraisemblance ($L_i$, $L'_i$) de la distribution statistique ($P_i$, $P'_i$),

e) pour un ensemble de plusieurs nœuds consommateurs (5), calculer (109) un indice (S ; $S_{cor}$) d'écart à la normalité en fonction des vraisemblances ($L_i$, $L'_i$) de la période d'observation (T) et de la période courante (T') des nœuds consommateurs (5),

f) comparer (111) l'indice (S ; $S_{cor}$) obtenu à une valeur seuil ($S_{ref}$) prédéfinie,

g) uniquement dans le cas où l'indice (S ; $S_{cor}$) obtenu dépasse la valeur seuil ($S_{ref}$), générer (113) un signal d'alerte.

2. Procédé selon la revendication 1, dans lequel l'indice (S ; $S_{cor}$) d'écart à la normalité est équivalent à une somme ou une moyenne des différences de vraisemblances ($L_i$, $L'_i$) entre la période d'observation (T) et la période courante (T') de chaque nœud consommateur (5).

3. Procédé selon l'une des revendications précédentes, dans lequel les requêtes et les réceptions de confirmations (OK) sont effectuées par Courtant Porteur en Ligne sur le réseau (1) de distribution électrique.

4. Procédé selon l'une des revendications précédentes, dans lequel la période d'observation (T) est sélectionnée parmi plusieurs en fonction des conditions de fonctionnement du réseau (1) de distribution électrique au cours de la période courante (T').

5. Procédé selon l'une des revendications précédentes, dans lequel :

- la période d'observation (T) s'étend sur une durée comprise entre 1 seconde et 100 jours,
- la période courante (T') s'étend sur une durée comprise entre 10 millisecondes et 7 jours,
- les instants successifs (t, t+1) de l'une au moins de la période d'observation (T) et de la période courante (T') sont mutuellement espacés d'une durée comprise entre 1 milliseconde et 24 heures, et/ou
- l'une au moins de la période d'observation (T) et de la période courante (T') comprend entre 2 et 500 instants successifs.

6. Procédé selon l'une des revendications précédentes, dans lequel les opérations sont mises en œuvre de manière répétée de sorte que les variable d'état ($B_{i,t}$) relatives à la période courante (T') sont mises à jour sensiblement en temps réel.

7. Procédé selon l'une des revendications précédentes, dans lequel les opérations sont mises en œuvre distinctement pour plusieurs ensembles de nœuds consommateurs (5) d'un même réseau (1).

8. Procédé selon la revendication 7, dans lequel la composition de chaque ensemble est sélectionnée en fonction des positions des nœuds consommateurs (5) sur le réseau (1) de sorte qu'un signal d'alerte est associé à une zone prédéfinie du réseau (1).

9. Module de détection d'anomalie sur un réseau (1) de distribution électrique comprenant une unité de traitement, le réseau (1) incluant une pluralité de nœuds consommateurs (5), l'unité de traitement (3) étant reliée au réseau (1) et chacun des nœuds consommateurs (5) étant apte à transmettre une confirmation (13) via le réseau (1) de distribution électrique en réponse à une requête (11) reçue par l'intermédiaire du réseau (1) de distribution électrique, l'unité de traitement étant agencée de manière à :

a) interroger (101) chacun des nœuds consommateurs (5) via le réseau (1) de distribution électrique à une pluralité d'instants (t) successifs d'une période d'observation (T) et à une pluralité d'instants (t') successifs d'une période courante (T'),

b) pour chaque interrogation, établir (103) une variable d'état ($B_{i,t}$) de type booléen dont la valeur correspond respectivement à la réception d'une confirmation (OK) ou à l'absence de réception d'une confirmation (KO),

c) pour chaque nœud consommateur (5) et pour chacune des périodes (T, T'), déduire (105) une distribution statistique ($P_i$, $P'_i$) des transitions d'états possibles (OK→OK, OK→KO, KO→OK, KO→KO) entre deux instants successifs,

d) pour chaque nœud consommateur (5) et pour chacune des périodes (T, T'), calculer (107) une vraisemblance ($L_i$, $L'_i$) de la distribution statistique ($P_i$, $P'_i$),

e) pour un ensemble de plusieurs nœuds consommateurs (5), calculer (109) un indice (S ; $S_{cor}$) d'écart à la normalité en fonction des vraisemblances ($L_i$, $L'_i$) de la période d'observation (T) et de la période courante (T') des nœuds consommateurs (5),

f) comparer (111) l'indice (S ; $S_{cor}$) obtenu à une valeur seuil ($S_{ref}$) prédéfinie,

g) uniquement dans le cas où l'indice (S ; $S_{cor}$) obtenu dépasse la valeur seuil ($S_{ref}$), générer (113) un signal d'alerte.

**10.** Programme informatique comportant des instructions pour la mise en œuvre du procédé selon l'une des revendications 1 à 8, lorsque ce programme est exécuté par un processeur.

**11.** Support d'enregistrement non transitoire lisible par un ordinateur sur lequel est enregistré un programme comprenant des instructions pour la mise en œuvre du procédé selon l'une des revendications 1 à 8.


**Patentansprüche**

**1.** Computerimplementiertes Verfahren zur Detektion einer Anomalie in einem elektrischen Verteilungsnetz (1) mit mehreren Verbraucherknoten (5), wobei jeder der Verbraucherknoten (5) dazu geeignet ist, eine Bestätigung über das elektrische Verteilungsnetz als Antwort auf eine über das elektrische Verteilungsnetz (1) empfangene Anfrage zu senden, wobei das Verfahren umfasst:

a) Sammeln (101) der Rückmeldungen zu Anfragen, die an jeden der Verbraucherknoten (5) über das elektrische Verteilungsnetz (1) zu mehreren aufeinanderfolgenden Zeitpunkten (t) einer Beobachtungsperiode (T) und zu mehreren aufeinanderfolgenden Zeitpunkten (t') einer aktuellen Periode (T') übertragen werden,

b) Erstellen (103) einer Zustandsvariable (Bi,t) vom Booleschen Typ, deren Wert jeweils dem Empfang einer Bestätigung (OK) oder dem Ausbleiben des Empfangs einer Bestätigung (KO) entspricht, für jede Anfrage,

c) Ableiten (105) einer statistischen Verteilung ($P_i$, $P'_i$) der möglichen Zustandsübergänge (OK → OK, OK → KO, KO → OK, KO → KO) zwischen zwei aufeinanderfolgenden Zeitpunkten für jeden Verbraucherknoten (5) und für jede der Perioden (T, T'),

d) Berechnen (107) einer Wahrscheinlichkeit ($L_i$, $L'_i$) der statistischen Verteilung ($P_i$, $P'_i$) für jeden Verbraucherknoten (5) und für jede der Perioden (T, T');

e) Berechnen (109) eines Index (S; $S_{cor}$) der Abweichung von der Normalität als Funktion der Wahrscheinlichkeiten ($L_i$, $L'_i$) der Beobachtungsperiode (T) und der aktuellen Periode (T') der Verbraucherknoten (5), für einen Satz mehrerer Verbraucherknoten (5),

f) Vergleichen (111) des erhaltenen Index (S; $S_{cor}$) mit einem vordefinierten Schwellenwert ($S_{ref}$),

g) nur falls der erhaltene Index (S; $S_{cor}$) den Schwellenwert ($S_{ref}$) überschreitet, Erzeugen (113) eines Warnsignals.

**2.** Verfahren nach Anspruch 1, wobei der Index (S; $S_{cor}$) der Abweichung von der Normalität einer Summe oder einem Durchschnitt der Unterschiede der Wahrscheinlichkeiten ($L_i$, $L'_i$) zwischen der Beobachtungsperiode (T) und der aktuellen Periode (T') jedes Verbraucherknotens (5) entspricht.

**3.** Verfahren nach einem der vorhergehenden Ansprüche, wobei die Anfragen und der Empfang von Bestätigungen (OK) vom PLC im elektrischen Verteilungsnetz (1) ausgeführt werden.

**4.** Verfahren nach einem der vorhergehenden Ansprüche, wobei die Beobachtungsperiode (T) in Abhängigkeit von den Betriebsbedingungen des elektrischen Verteilungsnetzes (1) während der aktuellen Periode (T') aus mehreren ausgewählt wird.

**5.** Verfahren nach einem der vorhergehenden Ansprüche, wobei:

- sich die Beobachtungsperiode (T) über einen Zeitraum zwischen 1 Sekunde und 100 Tagen erstreckt,
- sich die aktuelle Periode (T') über einen Zeitraum zwischen 10 Millisekunden und 7 Tagen erstreckt,
- die aufeinanderfolgenden Zeitpunkte (t, t + 1) der Beobachtungsperiode (T) oder/und der aktuellen Periode (T') um eine Dauer von zwischen 1 Millisekunde und 24 Stunden voneinander beabstandet sind, oder/und

- die Beobachtungsperiode (T) oder/und die aktuelle Periode (T') zwischen 2 und 500 aufeinanderfolgende Zeitpunkte umfasst.

6. Verfahren nach einem der vorhergehenden Ansprüche, wobei die Operationen wiederholt durchgeführt werden, so dass die Zustandsvariablen $(B_{i,t})$, die sich auf die aktuelle Periode (T') beziehen, im Wesentlichen in Echtzeit aktualisiert werden.

7. Verfahren nach einem der vorhergehenden Ansprüche, wobei die Operationen für mehrere Sätze von Verbraucherknoten (5) desselben Netzes (1) getrennt durchgeführt werden.

8. Verfahren nach Anspruch 7, wobei die Zusammensetzung jedes Satzes gemäß den Positionen der Verbraucherknoten (5) im Netz (1) ausgewählt wird, so dass ein Warnsignal einem vordefinierten Bereich des Netzes (1) zugeordnet wird.

9. Modul zur Detektion einer Anomalie in einem elektrischen Verteilungsnetz (1), umfassend eine Verarbeitungseinheit, wobei das Netz (1) mehrere Verbraucherknoten (5) enthält, wobei die Verarbeitungseinheit (3) mit dem Netz (1) verbunden ist und jeder der Verbraucherknoten (5) dazu geeignet ist, eine Bestätigung (13) über das elektrische Verteilungsnetz (1) als Antwort auf eine über das elektrische Verteilungsnetz (1) empfangene Anfrage (11) zu senden, wobei die Verarbeitungseinheit ausgebildet ist zum:

a) Abfragen (101) jedes der Verbraucherknoten (5) über das elektrische Verteilungsnetz (1) zu mehreren aufeinanderfolgenden Zeitpunkten (t) einer Beobachtungsperiode (T) und zu mehreren aufeinanderfolgenden Zeitpunkten (t') einer aktuellen Periode (T'),
b) Erstellen (103) einer Zustandsvariablen (Bi,t) vom Booleschen Typ, deren Wert jeweils dem Empfang einer Bestätigung (OK) bzw. dem Ausbleiben des Empfangs einer Bestätigung (KO) entspricht, für jede Abfrage,
c) Ableiten (105) einer statistischen Verteilung $(P_i, P'_i)$ möglicher Zustandsübergänge (OK $\rightarrow$ OK, OK $\rightarrow$ KO, KO $\rightarrow$ OK, KO $\rightarrow$ KO) zwischen zwei aufeinanderfolgenden Zeitpunkten, für jeden Verbraucherknoten (5) und für jede der Perioden (T, T'),
d) Berechnen (107) einer Wahrscheinlichkeit $(L_i, L'_i)$ der statistischen Verteilung $(P_i, P'_i)$, für jeden Verbraucherknoten (5) und für jede der Perioden (T, T'),
e) Berechnen (109) eines Index $(S; S_{cor})$ der Abweichung von der Normalität als Funktion der Wahrscheinlichkeiten $(L_i, L'_i)$ der Beobachtungsperiode (T) und der aktuellen Periode (T') der Verbraucherknoten (5), für einen Satz von mehreren Verbraucherknoten (5),
f) Vergleichen (111) des erhaltenen Index $(S; S_{cor})$, mit einem vordefinierten Schwellenwert $(S_{ref})$,
g) nur falls der erhaltene Index $(S; S_{cor})$ den Schwellenwert $(S_{ref})$ überschreitet, Erzeugen (113) eines Warnsignals.

10. Computerprogramm, umfassend Anweisungen zum Durchführen des Verfahrens gemäß einem der Ansprüche 1 bis 8, wenn dieses Programm von einem Prozessor ausgeführt wird.

11. Nicht-flüchtiges, computerlesbares Speichermedium, auf dem ein Programm aufgezeichnet ist, das Anweisungen zum Durchführen des Verfahrens gemäß einem der Ansprüche 1 bis 8 umfasst.

**Claims**

1. A computer-implemented method for detecting an anomaly on an electrical distribution network (1) including a plurality of consumer nodes (5), each of the consumer nodes (5) being capable of transmitting a confirmation via the electrical distribution network (1) in response to a request received through the electrical distribution network (1), the method comprising:

a) collecting (101) the request returns transmitted to each of the consumer nodes (5) via the electrical distribution network (1) at a plurality of successive time points (t) of an observation period (T) and at a plurality of successive time points (t') of a current period (T'),
b) for each request, establishing (103) a Boolean type state variable (Bi,t) whose value corresponds respectively to the reception of a confirmation (OK) or to the absence of reception of a confirmation (KO),
c) for each consumer node (5) and for each of the periods (T, T'), deducing (105) a statistical distribution $(P_i, P'_i)$ of possible state transitions (OK$\rightarrow$OK, OK$\rightarrow$KO, KO$\rightarrow$OK, KO$\rightarrow$KO) between two successive time points,

d) for each consumer node (5) and for each of the periods (T, T'), calculating (107) a likelihood ($L_i$, $L'_i$) of the statistical distribution ($P_i$, $P'_i$),

e) for a set of several consumer nodes (5), calculating (109) an index (S; $S_{cor}$) of deviation from normality depending on the likelihoods ($L_i$, $L'_i$) of the observation period (T) and the current period (T') of the consumer nodes (5),

f) comparing (111) the obtained index (S; $S_{cor}$) with a predefined threshold value ($S_{ref}$),

g) only in the case where the obtained index (S; $S_{cor}$) exceeds the threshold value ($S_{ref}$), generating (113) an alert signal.

2. The method according to claim 1, wherein the index (S; $S_{cor}$) of deviation from normality is equivalent to a sum or an average of the likelihood ($L_i$, $L'_i$) differences between the observation period (T) and the current period (T') of each consumer node (5).

3. The method according to one of the preceding claims, wherein the requests and receptions of confirmations (OK) are performed by Power Line Communication on the electrical distribution network (1).

4. The method according to one of the preceding claims, wherein the observation period (T) is selected from several depending on the operating conditions of the electrical distribution network (1) during the current period (T').

5. The method according to one of the preceding claims, wherein:

   - the observation period (T) extends over a duration comprised between 1 second and 100 days,
   - the current period (T') extends over a duration comprised between 10 milliseconds and 7 days,
   - the successive time points (t, t+1) of at least one of the observation period (T) and the current period (T') are mutually spaced by a duration comprised between 1 millisecond and 24 hours, and/or
   - at least one of the observation period (T) and the current period (T') comprises between 2 and 500 successive time points.

6. The method according to one of the preceding claims, wherein the operations are repeatedly implemented such that the state variables (Bi,t) relating to the current period (T') are updated substantially in real time.

7. The method according to one of the preceding claims, wherein the operations are implemented distinctly for several sets of consumer nodes (5) of the same network (1).

8. The method according to claim 7, wherein the composition of each set is selected depending on the positions of the consumer nodes (5) on the network (1) such that an alert signal is associated to a predefined area of the network (1).

9. A module for detecting an anomaly on an electrical distribution network (1) comprising a processing unit, the network (1) including a plurality of consumer nodes (5), the processing unit (3) being connected to the network (1) and each of the consumer nodes (5) being capable of transmitting a confirmation (13) via the electrical distribution network (1) in response to a request (11) received through the electrical distribution network (1), the processing unit being arranged to:

   a) query (101) each of the consumer nodes (5) via the electrical distribution network (1) at a plurality of successive time points (t) of an observation period (T) and at a plurality of successive time points (t') of a current period (T'),

   b) for each query, establish (103) a Boolean type state variable (Bi,t) whose value corresponds respectively to the reception of a confirmation (OK) or to the absence of reception of a confirmation (KO),

   c) for each consumer node (5) and for each of the periods (T, T'), deduce (105) a statistical distribution ($P_i$, $P'_i$) of possible state transitions (OK→OK, OK→KO, KO→OK, KO→KO) between two successive time points,

   d) for each consumer node (5) and for each of the periods (T, T'), calculate (107) a likelihood ($L_i$, $L'_i$) of the statistical distribution ($P_i$, $P'_i$),

   e) for a set of several consumer nodes (5), calculate (109) an index (S; $S_{cor}$) of deviation from normality depending on the likelihoods ($L_i$, $L'_i$) of the observation period (T) and the current period (T') of the consumer nodes (5),

   f) compare (111) the obtained index (S; $S_{cor}$) with a predefined threshold value ($S_{ref}$),

   g) only in the case where the obtained index (S; $S_{cor}$) exceeds the threshold value ($S_{ref}$), generate (113) an alert signal.

10. A computer program including instructions for implementing the method according to one of claims 1 to 8, when this program is executed by a processor.

11. A non-transitory computer-readable recording medium on which is recorded a program comprising instructions for implementing the method according to one of claims 1 to 8.

FIG. 1

FIG. 2

FIG. 3

FIG. 4

FIG. 5

FIG. 6

FIG. 7

FIG. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5568399 A
- WO 2015092279 A1
- US 2014278162 A1